# EUROPEAN PATENT SPECIFICATION

(11) **EP 1 957 687 B1**
(45) Date of publication and mention of the grant of the patent: **17.04.2013**
(21) Application number: 06829045.1
(22) Date of filing: 14.11.2006
(51) Int. Cl.: C23C 14/34

(54) **METHOD OF FABRICATING A TARGET.**
VERFAHREN ZUR HERSTELLUNG EINES TARGETS.
PROCEDE DE FABRICATION D'UNE CIBLE.

(30) Priority: 14.11.2005 RU 2005135023
(43) Date of publication of application: 20.08.2008
(73) Proprietor: AB SKF, 415 50 Göteborg (SE); JSC Scientific Industrial Enterprise Metal, 119049, Moscow (RU); National University of Science and Technology MISiS, 119049, Moscow (RU)
(72) Inventor: SANZ, Alejandro, NL-3437 VR Nieuwegein (NL); LEVASHOV, Evgeny, Alexandrovich, Moscow, 125080 (RU); SHTANSKY, Dmitry, Vladimirovich, Moscow, 125047 (RU); KURBATKINA, Viktoriya, Vladimirovna, Moscow, 121433 (RU)
(74) Representative: Andrae, Steffen
(86) International application number: PCT/EP2006/010918
(87) International publication number: WO 2007/054369

(56) References cited:
- JP-A- 55 097 472
- US-A- 4 209 375
- E.A.LEVASHOV ET AL: "Self-propagating high-temperature synthesis of functionally graded PVD targets with a ceramic working layer of TiB2-TiN or Ti5Si3-TiN" JOURNAL OF MATERIALS SYNTHESIS AND PROCESSING, vol. 10, no. 6, 1 November 2002 (2002-11-01), pages 319-330, XP002427614 US

## Description

### TECHNICAL FIELD

This invention relates to powder metallurgy, more specifically, to methods of fabricating hard alloy items using self-propagating high-temperature synthesis (SHS). This invention can be used in chemical, machine-tool construction and engineering industries and metallurgy for the synthesis of heat-resistant and mechanically strong coatings using ion-plasma sputtering.

### BACKGROUND

Known is a target for the synthesis of multifunctional coatings in the form of luminescent films (SU 1704920 A1, published 1992.01.15) that contains manganese doped aluminum nitride and unbound aluminum as a filler. A disadvantage of said target is the impossibility of its use for the synthesis of coatings using ion-plasma sputtering.

Known is a composite material (RU 2135327 C1, published 1999.08.27) containing a shaped metallic substrate and a functional layer of a ceramic material containing highly abrasive particles that is bonded to the substrate surface by metallic soldering through an intermediate layer. The material has high mechanical strength and thermal resistance (heat stability) of the bond between said metallic substrate and said ceramic material containing abrasive particles. A disadvantage of said material is the impossibility of its use for the synthesis of coatings using ion-plasma sputtering.

Also known is a target for the synthesis of functional coatings using ion-plasma sputtering (RU 2017846 C1, published 1994.08.15) in the form of a two-phase low-porosity titanium diboride - aluminum oxide composite material. Disadvantages of said target are the insufficient heat stability and mechanical strength.

Known is a method of fabricating a target for the synthesis of multifunctional coatings in the form of luminescent films (SU 1704920 A1, published 1992.01.15). The method comprises mixing aluminum and aluminum nitride powders in a manganese chloride containing liquid that wets the powders well and readily evaporates, drying, charge pressing and sintering at 660-700 °C in a protective atmosphere to fabricate a target for the synthesis of multifunctional coatings in the form of luminescent films containing manganese doped aluminum nitride and unbound aluminum as a filler. A disadvantage of said method is the impossibility of fabricating a target that could be used for ion-plasma sputtering.

Known is a method (RU 2135327 C1, published 1999.08.27) wherein SHS processing and subsequent pressing of powdered mixtures are used for the fabrication of a composite material containing a shaped metallic substrate and a functional layer of a ceramic material containing highly abrasive particles that is bonded to the substrate surface by metallic soldering through an intermediate layer. The material has high mechanical strength and thermal resistance of the bond between said metallic substrate and said ceramic material containing abrasive particles. A disadvantage of said method is the impossibility of its use for the synthesis of a material that could be used for ion-plasma sputtering.

Also known is a method of fabricating a target for the ion-plasma sputtering of coatings (RU 2017846 C1, published 1994.08.15) comprising the preparation of an exothermic mixture of metallic + nonmetallic powders of the following composition, wt.%: 15.03-33.81 aluminum, 13.35-30.05 titanium oxide, 11.62-28.14 boron oxide and 60.0-10.0 titanium diboride, mixture pelletizing, initiation of a burning reaction in the mixture, subsequent hot deformation, burning product exposure to high pressure and cooling. This method allows one to fabricate targets in the form of a two-phase low-porosity titanium diboride - aluminum oxide composite material. A disadvantage of said method is that the targets so fabricated have insufficient thermal resistance and mechanical strength.

In the publication E.A.LEVASHOV ET AL.: "Self-Propagating High-Temperature Synthesis of Functionally Graded PVD Targets with a Ceramic Working Layer of TiB2-TiN or T'5Si3-TiN", Journal of Materials Synthesis and Processing, Vol.10. No.6, pages 319-330, November 6, 2002, the preparation of a layered structure suitable as target for sputtering is described, using a self-propagating high-temperature synthesis (SHS) process initiated by triggering an exothermic reaction in an initiating layer, which SHS process converts underlying powder layers (pellets) into layers suitable as target materials, and subsequent hot pressing.

The layered structure obtained by the SHS process is not connected to a metal plate. Before sputtering a prepared target structure is fixed (mechanically or by welding), in a separate subsequent step, onto a water-cooled copper backing plate and then used as the cathode in a PVD sputtering system (see page 320, right column, lines 25-28).

It is the object of the present invention to provide an improved method for fabricating a target on a plate substrate for the synthesis of coatings using ion-plasma sputtering.

This object is achieved by providing a method according to claim 1.

Advantageous embodiments of the method of the invention are disclosed in claims 2 to 134.

### SUMMARY

This invention relates to powder metallurgy, more specifically, to methods of fabricating ceramics and hard alloy items using self-propagating high-temperature synthesis (SHS). This invention can be used in chemical, machine-tool construction and engineering industries and metallurgy for the synthesis of functional coatings (hard and superhard, corrosion- resistant, wear-resistant, heat-resistant, biocompatible, and mechanically strong) using ion-plasma sputtering.

The invention aims to prepare a target of a new quality level having improved thermal resistance, higher mechanical strength and thermal resistance of the bond with said metallic substrate capable of withstanding multicycle temperature variations involved during ion-plasma sputtering without destruction (lamination). For the method of fabricating a target for the synthesis of coatings, at least three pellets are fabricated to form said sputtered working layer, said intermediate layer and an initiating layer at least from three powdered mixtures having exothermal compositions capable of chemical interaction in SHS mode after the local heat-initiated reaction.

Further, said pellets of said sputtered working layer, said intermediate layer and said initiating layer are positioned in a layerwise (layer to layer) manner on said shaped metallic plate with a metallic solder charge layer. Further, an SHS process is started in said initiating layer that melts said metallic solder and said metallic filler comprised in the composition of the powdered mixture of at least one of said layers.

Further, said layers are exposed to high pressure by means of pressing in 2 - 10 seconds after the completion of the SHS process, the duration of said exposure being at least 5 seconds. As a result said sputtered working layer and said intermediate layer are bonded to said shaped metallic plate through said metallic solder layer. Finally, said initiating layer is removed.

The technical result of this invention is an increased thermal resistance of the target estimated as the number of cycles of ion-plasma (magnetron) sputtering to the initiation of lamination, reduction in the residual porosity of the sputtered working layer of the target and an increase in the degree of soldering estimated as the ratio of the solder surface area to the overall area of the contact surface of said metallic substrate.

The prepared target for the synthesis of coatings comprises a layer in the form of a shaped metallic plate to which the sputtered working layer in the form of a pellet based on ceramic material is bonded by means of a metallic solder through an intermediate layer in the form of a pellet based on ceramic material. Said sputtered working layer of said target comprises a porous skeleton structure of a material containing carbide and/or nitride and/or carbonitride and/or boride and/or silicide of a IV-VI groups of transition metal and/or calcium oxide and/or calcium phosphate and/or zirconium oxide and/or hydroxylapatite or a mixture thereof and a metallic filler filling the pores of said porous skeleton structure. Said sputtered working layer of said target preferably comprises a porous skeleton structure of a material containing a MSeₓ complex where M is a transition metal, and Se is selenium. When used for sputtering purposes, it leads to the generation of low friction self lubricated layers. These layers can be deposited either by using the working layer of the FGM (Functionally Graded Material) target or in parallel with sputtering a Se-free FGM target. The attained layers can be on one or more layers of mechanical parts, such as bearing parts.

Moreover, said sputtered working layer of the prepared target can comprise a porous skeleton structure of a material containing carbide and/or nitride and/or carbonitride and/or boride and/or silicide of a 4-6 column transition metal and/or calcium oxide and/or calcium phosphate and/or zirconium oxide and/or hydroxylapatite or a mixture thereof. Further, said intermediate layer comprises a porous skeleton structure of a material containing carbide and/or nitride and/or carbonitride and/or boride and/or silicide of a IV-VI groups of transition metal and/or calcium oxide and/or calcium phosphate and/or zirconium oxide and/or hydroxylapatite or a mixture thereof and a metallic filler filling the pores of said porous skeleton structure in a concentration ratio increasing gradually or in a stepwise manner in the direction from the interface of said sputtered working layer towards the interface of said metallic solder. Said stepwise variation of the concentration ratio between said skeleton structure and said metallic filler in said intermediate layer is achieved by the fabrication of said intermediate layer from at least two layers. Moreover, said metallic solder layer of said target comprises at least one element of the group including iron and/or copper and/or aluminum and/or other transition metals. Further, the thickness of said sputtered working layer of said target is 1 to 6 mm. The thickness of said intermediate layer is 0.5 to 4 mm. Further, the thickness of said metallic solder layer is 0.5 to 5 mm.

The technical result of this invention is a target of a new quality level having improved thermal resistance, higher mechanical strength and heat stability of the bond with said metallic substrate capable of withstanding multicycle temperature variations involved during ion-plasma sputtering without destruction (lamination).

For the method of fabricating a target for the synthesis of coatings, at least three pellets are fabricated to form said sputtered working layer, said intermediate layer and an initiating layer at least from three powdered mixtures having exothermal compositions capable of chemical interaction in SHS mode after the local heat-initiated reaction. Further, said pellets of said sputtered working layer, said intermediate layer and said initiating layer are positioned in a layerwise manner on said shaped metallic plate with a metallic solder charge layer. Further, the SHS process is started in said initiating layer that melts said metallic solder and said metallic filler comprised in the composition of the powdered mixture of at least one of said layers. Further, said layers are exposed to high pressure by means of pressing in 2 - 10 seconds after the completion of the SHS process, the duration of said exposure being at least 5 seconds. As a result said sputtered working layer and said intermediate layer are bonded to said shaped metallic plate through said metallic solder layer. Finally, said initiating layer is removed.

For this process, said sputtered working layer is a product of said SHS process and comprises a porous skeleton structure of a material containing carbide and/or nitride and/or carbonitride and/or boride and/or silicide of a IV-VI groups of transition metal and/or calcium oxide and/or calcium phosphate and/or zirconium oxide and/or hydroxylapatite or a mixture thereof and a metallic filler filling the pores of said porous skeleton structure. Moreover, said sputtered working layer is a product of said SHS process and comprises a porous skeleton structure of a material containing carbide and/or nitride and/or carbonitride and/or boride and/or silicide of a IV-VI groups of transition metal and/or calcium oxide and/or calcium phosphate and/or zirconium oxide and/or hydroxylapatite or a mixture thereof. According to other versions of the invention, said sputtered working layer is a product of said SHS process and suitably comprises a porous skeleton structure of a material containing a MSeₓ complex where M is a transition metal, and Se is selenium. When used for sputtering purposes, it leads to the generation of low friction self lubricated layers. These layers can be deposited either by using the working layer of the FGM (Functionally Graded Material) target or in parallel with sputtering a Se-free FGM target. The attained layers can be on one or more layers of mechanical parts, such as bearing parts.

Also, said intermediate layer is a product of said SHS process and comprises a porous skeleton structure of a material containing carbide and/or nitride and/or carbonitride and/or boride and/or silicide of, a IV-VI groups of transition metal and/or calcium oxide and/or calcium phosphate and/or zirconium oxide and/or hydroxylapatite or a mixture thereof and a metallic filler filling the pores of said porous skeleton structure in a concentration ratio increasing gradually or in a stepwise manner in the direction from the interface of said sputtered working layer towards the interface of said metallic solder.

Also, said stepwise variation of the concentration ratio between said skeleton structure and said metallic filler in said intermediate layer is achieved by the fabrication of said intermediate layer from at least two layers. Moreover, said metallic solder layer of said target comprises at least one element of the group including iron and/or copper and/or aluminum and/or other transition metals.

Also, during the preparation of said powdered mixtures said metallic filler is distributed in the form of a powder in said ceramic material forming said porous skeleton structure. Also, during the SHS process part of said metallic filler penetrates in the overlaying layers from said metallic solder charge.

Said metallic solder charge is fabricated in the form of a metallic sheet or metallic powder. Moreover, said pressing is achieved by means of direct pressing in a die or a mold or quasi isotopic pressing in a pressure transmitting medium or by pressing with a roll. Also, said pressure transmitting medium is molding sand.

### BRIEF DESCRIPTION OF THE DRAWING

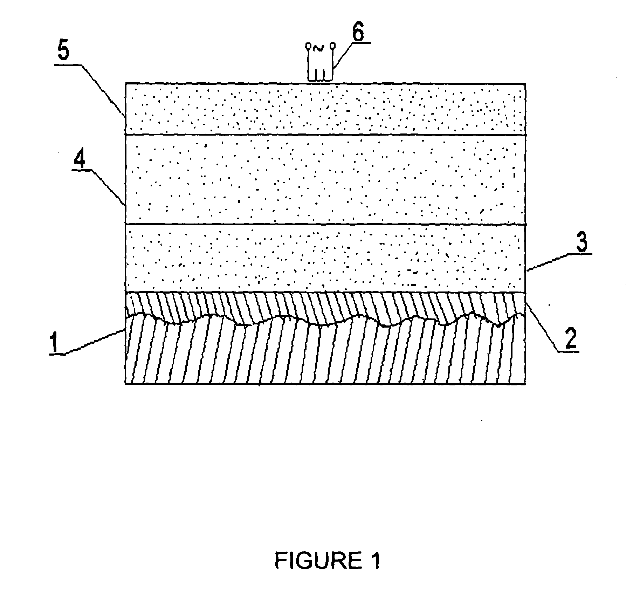

The invention will now be described in more detail for explanatory, and in no sense limiting, purposes, with reference to the following figure, in which
- Fig. 1: illustrates schematically a target for the synthesis of coatings and the method of its fabrication.

### DETAILED DESCRIPTION

In order to clarify the method and device according to the invention, some examples of its use will now be described in connection with Figure 1.

The target comprises a layer in the form of a shaped metallic plate (substrate) 1 to which a sputtered working layer 4 in the form of a pellet on the basis of a ceramic material is bonded by means of metallic solder 2 through an intermediate layer 3 in the form of a pellet on the basis of a ceramic material. The target fabrication process also comprises the use of an initiating layer 5 in the form of a pellet to which an initiating device 6 is attached.

In this invention, the SHS process is used for the synthesis of composite targets for the coatings deposition by ion-plasma sputtering. The SHS process occurs in exothermic mixture during combustion after the local heat-initiated reaction in the inflammation point. The SHS process is self-sustained and propagates in the rest of the material due to the intense heat generation and heat evolution that expands and causes a sufficient increase in temperature. This technology is suitable for the synthesis of various compounds such as carbides, nitrides, borides, silicides or oxides of IV-VI groups of metals including Ti, Zr, Ta and Si, as well as intermetallic compounds.

The SHS process which can create high temperatures almost adiabatically in a short time is used for the simultaneous or successive formation and sintering of pressed powders of various materials. For the fabrication of porousfree or porousless composite materials, such technologies are force SHS- pressing implemented by means of static pressing in a hydraulic press, instantaneous pressing by means of explosion, hot isostatic pressing (HIP) of the system or the quasi-HIP process during which the pressed pellet is squeezed by a mechanical press in the die through molding sand.

The method according to this invention is based on successive SHS and pressing. The metallic ingredients melt due to the intense SHS-induced heat emission and penetrate the skeleton structure of the resultant porous ceramic material thus filling the pores of this material. The resultant compacted structure of the material accounts for its high thermal resistance and wear resistance that are unattainable using conventional technologies.

Ceramic materials suitable for the synthesis of the porous skeleton structure include one or more carbides, nitrides and borides of IV-VI groups of transition metals, as well as SiC, Si3N4 and B4C. Of these materials, titanium or silicon carbide, nitride and boride are preferred from the viewpoint of process cost.

As a source raw material for the synthesis of the hard and dense composite material of the target layers, it is suggested to use a powdered mixture capable of chemical interaction in SHS mode for the synthesis of the hard material and metallic filler providing the synthesis of the alloy due to the SHS process. For a powdered mixture, e.g. (Ti+C)+(Ti+Al), one can synthesize a dense heat and wear resistant matrix containing a porous skeleton structure in the form of TiC grains and pores of which are filled by Ti-Al melt. The viscosity of the ceramic layer can be increased by adding nickel.

Metallic plate 1 according to this invention is formed using conventional structural materials, i.e. plastic metals, and the suitable composition of the material and the sizes are chosen such that to provide for a good matching of the clamping device and further processing depending on the intended final use.

Top target layers 4 and 3 and layers 2 and 3 are bonded using a method identical to soldering. The short, of the order of a few seconds, time during which the heat of the chemical reaction is generated and released is sufficient for melting the metallic solder layer and its strong binding with the metallic substrate without seriously affecting the properties of the entire metallic substrate. Substrate 1 can be made from various grades of conventional steels. Higher corrosion or wear resistance can be achieved by using ,stainless steel SUS (JIS) and copper, whereas titanium base materials are preferred for lighter structures. As said combination of metallic plate 1 and overlaying ceramic layer 4 may undergo cracking due to the difference in their thermal expansion coefficients at their interface, intermediate layer 3 in the form of a pressed metallic compound powder is added between said two layers. If necessary, intermediate layer 3 may comprise multiple various sublayers each of which being in the form of a pellet or pressed powdered mixture and having different compositions.

The short, of the order of a few seconds, heating time in the SHS process does not cause melt spreading over large distances to fill the gaps inside the porous skeleton structures. Therefore, to form a layer with reduced stresses, the composition of layer 3 should change in such a way that the fraction of the metallic filler in the ceramic materials decreases in a stepwise manner in the direction from the butt-end of plate 1 towards the butt-end of sputtered working layer 4 thereby minimizing the inhomogeneity of the resultant structure. The material of metallic solder 2 for binding melanic plate 1 with layers 3 and 4 should have, along with a relatively high melting point, good rupture strength and bending strength.

This invention is implemented as follows. First of all, at least three powdered mixtures are prepared, i.e. at least three charges the exothermal compositions of which are capable of chemical interaction in SHS mode after the local heat-initiated reaction. The metallic filler used for the preparation of said powdered mixtures is distributed in the form of a powder in the ceramic material forming a porous skeleton structure. Said powdered mixtures are processed to at least three pellets that are further SHS-processed to the sputtered working layer, the intermediate layer and the initiating layer 4, 3 and 5, respectively, based on ceramic materials and said metallic filler. Further, the pellets of intermediate layer 3, sputtered working layer 4 and initiating layer 5 are positioned in layers on shaped metallic plate 1 through the layer of metallic solder 2. The layer of metallic solder 2 comprises at least one element of the group including iron and/or copper and/or aluminum and/or other transition metals. The charge of metallic solder 2 is in the form of a metallic sheet or metallic powder. Further, the SHS process is started in initiating layer 5 using initiating device 6 and melts metallic solder 2 and said metallic filler in at least one of the layers 3, 4 and 5, respectively.

During the SHS process, part of said metallic filler penetrates in the overlaying layers 3 and 4 from metallic solder 2. In 2 - 10 seconds after the completion of the SHS process, layers 1, 2, 3, 4, and 5 are exposed to pressure. Said pressing is achieved by means of direct pressing in a die or a mold or quasi-isostatic pressing in a pressure transmitting medium or by pressing with a roll. Said pressure transmitting medium is molding sand. The duration of said exposure is at least 5 seconds. As a result, sputtered working layer 4 and intermediate layer 3 are bonded to shaped metallic plate 1 through said metallic solder layer. Finally, said initiating layer is removed.

Sputtered working layer 4 obtained as a product of said SHS process may comprise a porous skeleton structure of a material containing carbide and/or nitride and/or carbonitride and/or boride and/or silicide of a IV-VI groups of transition metal and/or calcium oxide and/or calcium phosphate and/or zirconium oxide and/or hydroxylapatite or a mixture thereof and a metallic filler filling the pores of said porous skeleton structure.

Sputtered working layer 4 obtained as a product of said SHS process may comprise a porous skeleton structure of a material containing carbide and/or nitride and/or carbonitride and/or boride and/or silicide of a IV-VI groups of transition metal and/or calcium oxide and/or calcium phosphate and/or zirconium oxide and/or hydroxylapatite or a mixture thereof.

Intermediate layer 3 obtained as a product of said SHS process may comprise a porous skeleton structure of a material containing carbide and/or nitride and/or carbonitride and/or boride and/or silicide of a IV-VI groups of transition metal and/or calcium oxide and/or calcium phosphate and/or zirconium oxide and/or hydroxylapatite or a mixture thereof and a metallic filler filling the pores of said porous skeleton structure in a concentration ratio increasing gradually or in a stepwise manner in the direction from the interface of said sputtered working layer towards the interface of said metallic solder.

Said stepwise variation of the concentration ratio between said skeleton structure and said metallic filler in said intermediate layer is achieved by the fabrication of said intermediate layer from at least two layers.

The thickness of said sputtered working layer of said target is 1 to 6 mm. The thickness of said intermediate layer is 0.5 to 4 mm. The thickness of said metallic solder layer is 0.5 to 5 mm.

Specific embodiments of this invention are summarized in the Table. The source powdered components in the specified ratio for each powdered mixture composition, i.e. different types of charge (see Table) are loaded in 3 liter capacity ball mills in an amount of 1,0 kg of charge per mill. Carbon for the process is added in the form of P804T grade glass black, and boron is added in the form of amorphous brown boron. The other materials are added in the form of standard powders with a grain size of less than 150 µm. The charge to ball weight ratio is chosen at 1:6. Mixing is achieved with balls 8-30 mm in diameter at atmospheric pressure for 6 hours. The final charge should not contain naked eye visible foreign inclusions and improperly mixed portions.

The charge is pressed in a DA-1532B hydraulic press in 127 mm inner diameter molds. Before pressing, the mold bottoms are lined with metallic, e.g. titanium, plates to act as the substrate layer for the targets. Then weighed portions of the preliminarily mixed charges are loaded into the molds as interchanging layers in the following order: the solder layer, the intermediate layer, the sputtered working target layer and the initiating layer, i.e. the so-called 'chemical furnace'. This 'chemical furnace' is a powdered mixture of a highly exothermal composition 75.6% Ti + 12.0% C + 12.4% B. The heat released by the combustion of this composition initiates the required chemical reactions in self-propagating high-temperature synthesis (SHS) mode in the charge of the sputtered working target layer and in the charge of the intermediate layer and, on the other hand, improves the moldability (due to the elevated temperature) of the refractory products of the synthesis in the sputtered working layer thereby reducing its residual porosity. For this diameter of mold, the weight of the 'chemical furnace' layer is 180 g. The weights of the other layers are summarized in Table 1. If the 'chemical furnace' layer is absent and the mixture is ignited directly from the side of the working layer (Experiment No. 30, Table 1) or if the weight of the 'chemical furnace' layer is insufficient, e.g. 100 g (Experiment No. 31, Table 1), the products of the synthesis in the sputtered working layer have a high residual porosity and are therefore not suitable for operation.

The 'chemical furnace' layer is separated from the rest of the charge with a heat-expanded graphite paper. The mold is assembled and installed under the press die. The multilayered charge pellet is formed under a 500 N/cm2 (5 MPa) pressure for 15 seconds. The ready charge pellet is squeezed out of the mold after the process is complete. The pellets should not have naked eye visible cracks, lamination, chipping and improperly pressed portions. The blanks are synthesized in a hydraulic press with a 160 tons pressure capacity and automatic control in a special reaction mold. The mold is installed onto the working table of the press, and the mold base section is filled with 0.6-0.8 kg of quartz sand to the top. The quartz sand is used as a pressure transmitting medium and a heat insulation layer avoiding direct contact of hot synthesis products with the inner surface of the mold and the dies. Moreover, the sand allows the off take of the gases emitted during the synthesis. The pressed pellet is installed onto the sand in the center of the reaction mold. The mold case, i.e. the press matrix is put onto the base. The initiating coil is inserted into the side electrodes of the mold case so that the coil touches the side surface of the 'chemical furnace' charge layer. The initiating coil is made from tungsten wire and should be U-shaped. The free space of the mold is filled with quartz sand and finally assembled. The mold is then installed under the press die. The preliminary processing pressure is set to 100 N/cm2 (1 MPa) at the pressure gage, and the main compaction pressure for the synthesis is set to 2 MPa. The required synthesis parameters are set at the press automatic control unit, i.e. a 0.5 seconds initiation time, the delay time from the completion of the SHS process to the application of the main compaction pressure for the synthesis (values in the Table) and the time of synthesis products exposure to pressure (values in the Table). The initiation voltage is 20 - 25 V. The synthesis process starts after the receipt of an appropriate signal from the automatic control unit. After the press dies returns to the upper position, the protective doors of the press open automatically, and the mold moves out from the press for further disassembly.

For synthesis in a hard mold without sand, i.e. with a direct contact of hot synthesis products with the inner surface of the metallic press matrix and the dies, the synthesis products cool down quite rapidly due to the high heat losses, the time of the viscous plastic state reduces, and the residual porosity of the final product exceeds the limit and leads to rejects (Experiment No. 11, Table 1).

The hot blank is removed from the mold with special pincers and placed into a muffle furnace located near the press and heated to 900°C beforehand. Then the blanks with the furnace are cooled down to room temperature; this reduces the residual stresses and avoids cracking. The initiating layer is removed from the cooled blanks.

If the hot blank is not slowly cooled down with the furnace (Experiment No. 12, Table 1), i.e. for rapid air cooling without heat treatment (annealing), the high residual stresses unavoidably reduce the thermal resistance of the target and cause its early cracking during sputtering.

Then the contact surfaces of the blanks are ground. 3-5 blanks are glued with a colophony/paraffin mixture onto a frame installed on the magnetic table of a 3E 711 V plain grinder. The blanks are ground with APP 250x40x5x76 ASR 160/125-B diamond grinding discs, 100% cutting emulsion. After blank surface leveling they are automatically ground, and the processed surface is then processed on a hard support to 9-10 grade cleanliness. The other sides of the blanks are ground to the required thickness similarly.

The target sizes and surface quality are controlled for 100% of targets in every batch. Cracked targets and those not meeting the required chemical composition are rejected. The main target quality criteria are thermal resistance of the target estimated as the number of cycles of ion-plasma (magnetron) sputtering to the initiation of lamination, reduction in the residual porosity of the sputtered working layer of the target and an increase in the degree of soldering estimated as the ratio of the solder surface area to the overall area of the contact surface of said metallic substrate. The following parameter values are considered acceptable for the targets: thermal resistance of more than 200 cycles, residual porosity of within 3% and degree of soldering of at least 95%.

In Experiments Nos. 1 - 31, 4 mm thick VT3-1 titanium alloy plates were used, and in Experiments Nos. 32 - 37, 3 to 10 mm thick copper plates with various types of solders. The thicker the plate, the lower the target quality and hence the higher the residual porosity and the lower the degree of soldering due to the higher heat losses. This, there is an optimum plate thickness, and a specific type of solder should be selected for each plate material.

Multilayered targets are can be alternatively fabricated by deforming hot synthesis products on a rolling mill (the SHS rolling technology) (Experiments Nos. 38 - 40). This technology allows one to fabricate rectangular segments for planar targets. Charge pellets are pressed in a DA-1532B hydraulic press in 140×110 mm inner section rectangular molds. By analogy with disc-shaped molds, rectangular molds are lined with titanium plates to act as the substrate layer for the targets. Then weighed portions of the preliminarily mixed charges are loaded into the molds as interchanging layers in the following order: the solder layer, the intermediate layer, the sputtered working target layer and the initiating layer of the 'chemical furnace'.

The weight of the 'chemical furnace' layer is 300 g. The mold is assembled and installed under the press die. The multilayered charge pellet is formed under a 6 MPa pressure for 15 seconds. The ready charge pellet is squeezed out of the mold after the process is complete. The pellets should not have naked eye visible cracks, lamination, chipping and improperly pressed portions.

Multilayered targets are synthesized and deformed in a vacuum rolling mill using a method described elsewhere. The rolling mill comprises the following successive chambers: the loading chamber, the heating chamber, the main rolling chamber with 155 mm diameter rolls and the cooling and rolled blank unloading chamber. The loading and unloading chambers are separated from the main rolling chamber by vacuum docks allowing their individual pressurization with independent vacuum pumps and preserving the vacuum in the main working chamber of the rolling mill during loading and unloading. The charge pellets are placed in reusable gas-proof steel sheaths. The 'chemical furnace' layer is separated from the rest of the charge with a heat-expanded graphite paper. This paper is also placed between the metallic sheaths and the charge. Before the initiation of the SHS reaction, the charge pellet with the sheath was exposed to thermal vacuum treatment (TVT) directly in the heating chamber of the rolling mill at 750°C for 30 min. TVT significantly reduces gas emission during vacuum SHS and thus avoids pulverization of the charge and the hot synthesis products. The SHS process in the 'chemical furnace' layer is initiated with a tungsten coil installed in the main rolling chamber directly before the rolls. The initiation voltage is 20 - 25 V. The synthesis process starts after the receipt of an appropriate signal from the automatic control unit of the rolling mill. SHS process start and end are recorded automatically and detected from change in the pressure inside the vacuum chamber, because gas emission reduces the degree of vacuum even if the vacuum pumps are still on. Immediately after the completion of the SHS process the sheath with hot synthesis products is fed to the rolls where the synthesis products are squeezed to a preset deformation (E) in the range from 50 to 80%. Then the sheath with hot synthesis products is fed to the unloading chamber where it is slowly cooled. The sheath is then disassembled, and the 'chemical furnace' layer is removed from the cooled blanks. It can be seen from the Table (Experiment No. 38) that 70% deformation provides for a high-quality, almost pore-free segmented target.

Then the contact surfaces and edges of the segments are ground. 3-5 blanks are glued with a colophony/paraffin mixture onto a frame installed on the magnetic table of a 3E 711 V plain grinder. The blanks are ground with APP 250x40x5x76 ASR 160/125-B diamond grinding discs, 100% cutting emulsion.

**Table**

| # | Sputtered Working Target Layer Composition and Weight, %/g | | Intermediate Target Layer Composition and Weight, %/g. | | Solder Composition and Weight, %/g | Intermediate Layer Thickness, mm | Solder Thickness, mm | Delay / Exposure Time, s | Thermal Resistance, No. of Sputtering Cycles | Sputtered Working Layer Residual Porosity, % | Degree of Soldering to the Plate, % |
|---|---|---|---|---|---|---|---|---|---|---|---|
| | Initial Charge | Synthesis Products | Initial Charge | Synthesis Products | | | | | | | |
| 1 | Ti- 82 | Ti₅Si₃, Ti | Ti- 86 | TiB, Ti | Ti- 100 | 3 | 1 | 2/10 | 200 | 3 | 100 |
| | Si- 18 | | B- 14 | | | | | | | | |
| | **250 g** | | **150 g** | | **50 g** | | | | | | |
| 2 | Ti- 82 | Ti₅Si₃, Ti | Ti- 86 | TiB, Ti | No | 6 | 5 | 20/10 | 0 | 3 | 20 |
| | Si-18 | | B- 14 | | Solder | | | | | | |
| | **350 g** | | **40 g** | | | | | | | | |
| 3 | Ti- 82 | Ti₅Si₃, Ti | Ti- 86 | TiB, Ti | Ti- 100 | 5 | 6 | 10/5 | 80 | 3 | 70 |
| | Si- 18 | | B- 14 | | | | | | | | |
| | **200 g** | | **200 g** | | **10** g | | | | | | |
| 4 | Ti- 82 | Ti₅Si₃, Ti | Ti- 86 | TiB, Ti | Ti- 100 | 0,5 | 0,4 | 10/30 | 0 | 16 | 40 |
| | Si- 18 | | B- 14 | | | | | | | | |
| | **250** g | | **150 g** | | **100 g** | | | | | | |
| 5 | Ti- 82 | Ti₅Si₃, Ti | No Intermediate Layer | - | Ti- 100 | - | 5 | 3/20 | 50 | 3 | 100 |
| | Si- 18 | | | | | | | | | | |
| | **250 g** | | | | **50 g** | | | | | | |
| 6 | Ti- 82 | Ti₅Si₃, Ti | No Intermediate Layer | | No | - | - | 3/10 | 20 | 3 | - |
| | si- 18 | | | | Solder | | | | | | |
| | **250 g** | | | TiD, Ti | | | | | | | |
| 7 | Ti- 82 | Ti₅Si₃, Ti | Ti- 86 | TiB, Ti | Ti- 100 | 4 | 4 | 3/20 | 70 | 3 | 100 |
| | Si- 18 | | B- 14 | | | | | | | | |
| | **70 g** | | **300 g** | | **50 g** | | | | | | |
| 8 | Ti- 82 | Ti₅Si₃, Ti | Ti- 86 | TiB, Ti | Ti- 100 | 0,4 | 4 | 4/10 | 0 | 18 | 30 |
| | Si- 18 | | B- 14 | | | | | | | | |
| | **250 g** | | **150 g** | | **50** g | | | | | | |
| 9 | Ti- 82 | Ti₅Si₃, Ti | Ti- 86 | TiB, Ti | Ti- 100 | 3 | 4 | 5/15 | 0 | 3 | 60 |
| | Si- 18 | | B- 14 | | | | | | | Lamination | |
| | **250 g** | | **150 g** | | **50 g** | | | | | | |
| 10 | Ti- 82 | Ti₅Si₃, Ti | tri- 16 | TiB, Ti | Ti- 100 | 5 | 4 | 10/4 | 0 | 20 | 20 |
| | Si- 18 | | B- 14 | | | | | | | Lamination | |
| 11 | Ti- 82 | Ti₅Si₃, Ti | Ti- 86 | TiB, Ti | Ti- 100 | 5 | 6 | 3/5 Synthesis in Hard Molds without Sand | 0 | 16 | 60 |
| | Si- 18 | | B- 14 | | | | | | | | |
| | **250 g** | | **150 g** | | **50 g** | | | | | | |
| 12 | Ti- 82 | Ti₅Si₃, Ti | Ti- 86 | TiB, Ti | Ti- 100 | 4 | 6 | 5/5 Rapid Air Cooling without Heat Treatment in Furnace | 15 | 3 | 100 |
| | Si- 18 | | B- 14 | | | | | | | | |
| | **250 g** | | **150 g** | | **50 g** | | | | | | |
| 13 | Ti-75.4 | TiN, Ti₅Si₃ | Ti- 80.7 | Ti, TiB, TiN, Ti₅Si₃ | Co- 90 | 3 | 4 | 10/7 | 280 | 1 | 98 |
| | Si₃N₄- 24.6 | | B- 7 | | Al. 1 0 | | | | | | |
| | | | Si₃N₄- 12.3 | | | | | | | | |
| | **250 g** | | **90g** | | **85 g** | | | | | | |
| 14 | Ti- 74. 3 | TiB₂, TiN | Ti- 80.2 | Ti, TiB, TiB₂, TiN | Fe- 100 | 3 | 4 | 5/10 | 210 | 2 | 95 |
| | BN- 25.7 | | BN-12.8 | | | | | | | | |
| | | | B- 7 | | | | | | | | |
| | **240 g** | | **90 g** | | **80 g** | | | | | | |
| 15 | Ti- 80.1 | TiC, CaO | Ti- 86 | TiB, Ti | Ti-100 | 4 | 3 | 2/8 | 200 | 2 | 100 |
| | C- 9.9 | | B- 14 | | | | | | | | |
| | CaO- 10 | | | | | | | | | | |
| | **250 g** | | **90 g** | | **50 g** | | | | | | |
| 16 | Ti- 71.2 | TiC, CaO | Ti- 78.6 | Ti, TiB, TiC, | Fe- 50 | 2 | 3 | 2/10 | 250 | 2 | 99 |
| | C- 8.8 | | B- 7 | CaO | Cu- 50 | | | | | | |
| | CaO-20 | | C- 4.4 | | | | | | | | |
| | | | CaO- 10 | | | | | | | | |
| | **220 g** | | **100 g** | | **95 g** | | | | | | |
| 17 | Ti-80.1 | TiC, ZrO₂ | Ti- 86 | TiB, Ti | Cu-80 | 2 | 3 | 3/8 | 230 | 2 | 100 |
| | C- 9.9 | | B- 14 | | Al-20 | | | | | | |
| | ZrO₂- 10 | | | | | | | | | | |
| | **250 g** | | **90 g** | | **75 g** | | | | | | |
| 18 | Ta- 92 | TaC | Ti- 90 | TiC, Ti | Ti-100 | 1 | 2 | 2/5 | 240 | 1 | 100 |
| | C-8 | | C- 10 | | | | | | | | |
| | **580 g** | | **90 g** | | **50 g** | | | | | | |
| 19 | Nb-40.5 | TiB₂, NbH₂ | Ti- 86 | TiB, Ti | Ti-1000 | 1 | 2 | 3/5 | 200 | | 98 |
| | Ti- 34.5 | | B- 14 | | | | | | | | |
| | B- 25 | | | | | | | | | | |
| | **420 g** | | **90** g | | **50 g** | | | | | | |
| 20 | Cr- 56 | CrB₂, AlN | Sublayer 1: | TiB, Ti | Ti- 94 | 4 | 2 | 4/16 | 280 | 2 | 100 |
| | B- 24 | | Ti- 86 | | Al- 6 | | | | | | |
| | AlN-20 | | B- 14 | | **45 g** | | | | | | |
| | **200 g** | | **30** g | | | | | | | | |
| | | | Sublayer 2: | TiB, Ti, CrB₂ | | | | | | | |
| | | | Ti- 75 | | | | | | | | |
| | | | B- 15 | | | | | | | | |
| | | | Cr- 10 | | | | | | | | |
| | | | **30** g | | | | | | | | |
| | | | Sublayer 3: | CrB₂, TiB, Ti, AlN | | | | | | | |
| | | | Ti- 30 | | | | | | | | |
| | | | B- 22 | | | | | | | | |
| | | | Cr- 38 | | | | | | | | |
| | | | AlN- 10 | | | | | | | | |
| | | | **30** g | | | | | | | | |
| 21 | Cr- 56 | CrB₂, AlN | Ti- 86 | TiB, Ti | Ti- 94 | 2 | 3 | 15/16 | 80 | 5 | 80 |
| | B- 24 | | B- 14 | | Al- 6 | | | | | | |
| | AlN-20 | | | | **45 g** | | | | | | |
| | **200 g** | | **90 g** | | | | | | | | |
| 22 | Cr- 56 | CrB₂, AlN | Sublayer 1: | TiB, Ti | Ti- 94 | 3 | 3 | 2/16 | 110 | 7 | 90 |
| | B- 24 | | Ti- 86 | | Al- 6 | | | | | | |
| | AlN-20 | | B- 14 | | **45** g | | | | | | |
| | **200 g** | | **45 g** | | | | | | | | |
| | | | Sublayer 2: | TiB, Ti, CrB₂ | | | | | | | |
| | | | Ti- 75 | | | | | | | | |
| | | | B- 15 | | | | | | | | |
| | | | Cr- 10 | | | | | | | | |
| | | | 45 g | | | | | | | | |
| 23 | Cr- 56 | CrB₂. AlN | Sublayer 1: | TiB, Ti | Ti- 94 | 2 | 3 | 5/16 | 120 | 8 | 85 |
| | B- 24 | | Ti- 86 | | Al- 6 | | | | | | |
| | AIN-20 | | B- 14 | | **45 g** | | | | | | |
| | **200 g** | | **45 g** | | | | | | | | |
| | | | Sublayer 2 | CrB₂, TiB, Ti, | | | | | | | |
| | | | Ti- 30 | AlN | | | | | | | |
| | | | B- 22 | | | | | | | | |
| | | | Cr- 38 | | | | | | | | |
| | | | AlN- 10 | | | | | | | | |
| | | | **45 g** | | | | | | | | |
| 24 | Cr- 56 | CrB₂, AlN | Sublayer 1: | TiB, Ti | No Solder | 3 | - | 5/16 | 0 | 2 | 10 |
| | B- 24 | | Ti- 86 | | | | | | | | |
| | AlN-20 | | B- 14 | | | | | | | | |
| | **200 g** | | **30** g | | | | | | | | |
| | | | Sublayer 2: | TiB, Ti, CrB₂ | | | | | | | |
| | | | Ti- 75 | | | | | | | | |
| | | | B- 15 | | | | | | | | |
| | | | Cr- 10 | | | | | | | | |
| | | | 30 g | | | | | | | | |
| | | | Sublayer 3: | CrB₂, TiB, Ti, | | | | | | | |
| | | | Ti- 30 | AlN | | | | | | | |
| | | | B- 22 | | | | | | | | |
| | | | Cr- 38 | | | | | | | | |
| | | | AlN- 10 | | | | | | | | |
| | | | **30** g | | | | | | | | |
| 25 | Ti- 73,8. | Ti₅Si₃, CaO | Tri-45 | TiNi | Ni-90 | 3 | 3 | 5/20 | 280 | 3 | 100 |
| | Si- 16,2 | | Ni-55 | | Al-10 | | | | | | |
| | CaO- 10 | | | | | | | | | | |
| | **250 g** | | **120 g** | | **70 g** | | | | | | |
| 26 | Ti-34,5 | TiB₂, | Ti-90 | TiC, Ti | Cu-80 | 4 | 3 | 8/8 | 220 | 3 | 100 |
| | B**-** 15,5 | Al₂O₃ | C-10 | | Sn-20 | | | | | | |
| | Al₂O₃- 50 | | | | | | | | | | |
| | **100 g** | | **90 g** | | **78 g** | | | | | | |
| 27 | Ti- 71.2 | TiC, CaTiO₃ | Ti- 78.6 | TiB, Ti, TiC, CaTiO₃ | Ti-100 | 4 | 4 | 7/5 | 200 | 2 | 100 |
| | C- 8.8 | | B- 7 | | | | | | | | |
| | TiO_{z}- 11.8 | | C- 4.4 | | | | | | | | |
| | CaO- 8.2 | | TiO_{z}- 5.9 | | | | | | | | |
| | | | CaO- 4.1 | | | | | | | | |
| | **250 g** | | **90** g | | **50 g** | | | | | | |
| 28 | Ti- 80.1 | TiiC, Ca₃(PO₄)₂ | Ti- 83.1 | TiB, Ti, TiC, Ca₃(PO₄)₂ | Ti-100 | 3 | 2 | 2/6 | 210 | 1 | 100 |
| | C- 9.9 | | B- 7 | | | | | | | | |
| | Ca₃(PO₄)₂- 10 | | C- 4.9 | | | | | | | | |
| | | | Ca₃(PU₄)₂- 5 | | | | | | | | |
| | **250 g** | | **90 g** | | **50 g** | | | | | | |
| 29 | Ti- 80.1 | TiC, Ca₁₀(PO₄)₆(OH)₂ | Ti- 83.1 | TiB, Ti, TiC, | Ni- 100 | 3 | 1 | 2/8 | 200 | 2 | 100 |
| | C- 9.9 | | B- 7 | Ca₁₀(PO₄)₆(OH)₂ | | | | | | | |
| | Ca₁₀(PO₄)₆(OH)r | | C- 4.9 | | | | | | | | |
| | 10 | | Ca₁₀(PO₄)₆₍OH)₂-5 | | | | | | | | |
| | | | | | | | | | | | |
| | **250** g | | **90g** | | **110 g** | | | | | | |
| 30 | Ti- 80.1 | TiC, Ca₁₀(PO₄)₆(OH)₂ | Ti- 83.1 | TiB, Ti, TiC, | Ni- 100 | 3 | 1 | 2/3 Synthesis without 'Chemical Furnace' | 0 | 30 | 30 |
| | C- 9.9 | | B- 7 | Ca₁₀(PO₄)₆(OH)₂ | | | | | | | |
| | Ca₁₀(PO₄)₆(OH)₂-10 | | C- 4.9 | | | | | | | | |
| | | | Ca₁₀(PO₄)₆(OH)₂-5 | | | | | | | | |
| | | | | | | | | | | | |
| | **250** g | | **90 g** | | **110 g** | | | | | | |
| 31 | Ti- 80.1 | TiC, Ca₁₀(PO₄)₆(OH)₂ | Ti- 83.1 | TiB, Ti, TiC, | Ni- 100 | 4 | 1 | 2/4 'Chemical Furnace' Weight 100 g | 0 | 26 | 60 |
| | C- 9.9 | | B- 7 | Ca₁₀(PO₄)₆(OH)₂ | | | | | | | |
| | Ca₁₀(PO₄)₆OH)₂ | | C- 4.9 | | | | | | | | |
| | 10 | | Ca₁₀(PO₄)₆OH)₂-5 | | | | | | | | |
| | | | | | | | | | | | |
| | **250 g** | | **90 g** | | **110 g** | | | | | | |
| 32 | Ti- 80.1 | TiC, Ca₁₀(PO₄)₆(OH)₂ | Ti- 83.1 | TiB, Ti, TiC, | Cu- 80 | 3 | 2 | 2/8 3 mm Thick Copper Plate | 210 | 3 | 98 |
| | C- 9.9 | | B- 7 | Ca₁₀(PO₄)₆(OH)₂ | Sn- 20 | | | | | | |
| | Ca₁₀(PO₄)₆₍OH)₂-10 | | C- 4.9 | | | | | | | | |
| | | | Ca₁₀(PO₄)₆(OH)₂-5 | | | | | | | | |
| | | | | | | | | | | | |
| | **250** g | | **90 g** | | **110 g** | | | | | | |
| 33 | Ti- 80.1 | TiC, Ca₁₀(PO₄)₆(OH)₂ | Ti- 83.1 | TiB, Ti, TiC, | Cu- 80 | 3 | 6 | 2/1 2 mm Thick Copper Plate | 0 | 2 | 100 |
| | C- 9.9 | | B- 7 | Ca₁₀(PO₄)₆(OH)₂ | Sn- 20 | | | | Plate Deformed | | |
| | Ca₁₀(PO₄)₆(OH)₂-10 | | C- 4.9 | | | | | | | | |
| | | | Ca₁₀(PO₄)₆OH)₂-5 | | | | | | | | |
| | | | | | | | | | | | |
| | **250 g** | | **90 g** | | **110 g** | | | | | | |
| 34 | Ti- 80.1 | TiC, Ca₁₀(PO₄)₆(OH)₂ | Ti- 83.1 | TiB, Ti, TiC, | Cu- 80 | 3 | 0,4 | 11/8 10 mm Thick Copper Plate | 0 | 25 | 15 |
| | C- 9.9 | | B- 7 | Ca₁₀(PO₄)₆(OH)₂ | Sn- 20 | | | | | | |
| | Ca₁₀(PO₄)₆(OH)₂-10 | | C- 4.9 | | | | | | | | |
| | | | Ca₁₀(PO₄)₆₍OH)₂-5 | | | | | | | | |
| | 250 | | 90 g | | 110 g | | | | | | |
| 35 | Ti- 80.1 | TiC, Ca₁₀(PO₄)₆(OH)₂ | Ti- 83.1 | TiB, Ti, TiC, Ca₁₀(PO₄)₆(OH)₂ | Cu- 80 | 3 | 2 | 2/8 | 200 | 3 | 95 |
| | C- 9.9 | | B- 7 | | Al - 20 | | | 3 mm Thick | | | |
| | Ca₁₀(PO₄)₆(OH)₂-10 | | C-4.9 | | | | | Copper | | | |
| | | | Ca₁₀(PO₄)₆(OH)₂-5 | | | | | Plate | | | |
| | | | | | | | | | | | |
| | **250 g** | | **90 g** | | **110 g** | | | | | | |
| 36 | Ti- 80.1 | TiC, Ca₁₀(PO₄)₆(OH)₂ | Ti- 83.1 1 | TiB, Ti, TiC, Ca₁₀(PO₄)₆(OH)₂ | Ti- 100 | 3 | 3 | 2/8 | 0 | 3 | 70 |
| | C- 9.9 | | B- 7 | | | | | 3 mm Thick | | | |
| | Ca₁₀(PO₄)₆(OH)₂-10 | | C- 4.9 | | | | | Copper | | | |
| | | | Ca₁₀(PO₄)₆(OH)₂-5 | | | | | Plate | | | |
| | | | | | **110 g** | | | | | | |
| | **250 g** | | **90g** | | | | | | | | |
| 37 | Ti- 80.1 | TiC, Ca₁₀(PO₄)₆(OH)₂ | Ti- 83.1 | TiB, Ti, TiC, Ca₁₀(PO₄)₆(OH)₂ | Ni- 90 | 3 | 2 | 2/8 | 0 | 2 | 60 |
| | C- 9.9 | | B- 7 | | Al- 10 | | | 3 mm Thick | | | |
| | Ca₁₀(PO₄)(OH)₂-10 | | C- 4.9 | | | | | Copper | | | |
| | | | Ca₁₀(PO₄)₆(OH)₂-5 | | | | | Plate | | | |
| | | | | | | | | | | | |
| | **250 g** | | **90 g** | | **110 g** | | | | | | |
| 38 | Ti- 82 | Ti₅Si₃, Ti | Ti- 86 | TiB, Ti | Ti- 100 | 3 | 3 | Rolling to | 220 | 3 | 100 |
| | Si- 18 | | B- 14 | | | | | E = 70% | | | |
| | **310 g** | | **165 g** | | **60 g** | | | | | | |
| 39 | Ti- 82 | Ti₅Si₃, Ti | Ti- 86 | TiB, Ti | Ti- 100 | 3 | 3 | Rolling to | 0 | 35 | 50 |
| | Si- 18 | | B- 14 | | | | | E=25% | | | |
| | **310 g** | | **165 g** | | **60 g** | | | | | | |
| 40 | Ti- 82 | Ti₅Si₃, Ti | Ti- 86 | TiB, Ti | Ti- 100 | 6 | 2 | Rolling to | 60 | 15 | 90 |
| | Si- 18 | | B- 14 | | | | | E = 60% | | | |
| | **310 g** | | **165 g** | | **60 g** | | | | | | |

## Claims

1. Method of fabricating a target for the synthesis of coatings using ion-plasma sputtering, wherein
- at least three pellets are fabricated to form an initiating layer, a sputtered working layer and an intermediate layer using at least three powder mixtures having compositions capable of exothermic chemical interaction in a self-propagating high-temperature synthesis (SHS) mode after a local heat-initiated reaction,
- said pellets of said initiating layer, said sputtered working layer and said intermediate layer being positioned in a layered manner on a shaped metallic plate substrate carrying a metallic solder charge layer,
- the SHS process is started in said initiating layer and the heat developed melts said metallic solder and said metallic filler comprised in the composition of the powdered mixture of at least one of said layers,
- exposing said layers to high pressure by means of pressing within 2 - 10 seconds after the completion of the SHS process, the duration of said exposure being at least 5 seconds,
- obtaining a target product in which as the result of the SHS process and the pressing said sputtered working layer and said intermediate layer are bonded to said shaped metallic plate substrate through said metallic solder layer, and
- finally removing said initiating layer.

2. Method according to Claim 1, wherein said sputtered working layer is a product of said SHS process and comprises a porous skeleton structure of a material containing a carbide and/or nitride and/or carbonitride and/or boride and/or silicide of a transition metal of groups IV to VI of the periodic table of elements and/or calcium oxide and/or calcium phosphate and/or zirconium oxide and/or hydroxyapatite or a mixture thereof, and a metallic filler filling the pores of said porous skeleton structure.

3. Method according to Claim 1, wherein said sputtered working layer is a product of said SHS process and comprises a porous skeleton structure of a material containing a carbide and/or nitride and/or carbonitride and/or boride and/or silicide of a transition metal of groups IV to VI of the periodic table of elements and/or calcium oxide and/or calcium phosphate and/or zirconium oxide and/or hydroxyapatite or a mixture thereof.

4. Method according to Claim 1, wherein said intermediate layer is a product of said SHS process and comprises a porous skeleton structure of a material containing a carbide and/or nitride and/or carbonitride and/or boride and/or silicide of a transition metal of groups IV to VI of the periodic table of elements and/or calcium oxide and/or calcium phosphate and/or zirconium oxide and/or hydroxyapatite or a mixture thereof, and a metallic filler filling the pores of said porous skeleton structure of said intermediate layer in a concentration ratio increasing gradually in the direction from the interface of said sputtered working layer towards the interface of said metallic solder.

5. Method according to Claim 1, wherein said metallic solder layer of said target comprises at least one element of the group consisting of iron and/or copper and/or aluminum and/or other transition metals.

6. Method according to Claim 1, wherein during the preparation of said powder mixtures said metallic filler is distributed in the form of a powder in said ceramic material forming said porous skeleton structure.

7. Method according to Claim 1, wherein during the SHS process part of said metallic filler penetrates in the overlaying layers from said metallic solder charge.

8. Method according to Claim 1, wherein said metallic solder charge is provided in the form of a metallic sheet or metallic powder.

9. Method according to Claim 1, wherein said pressing is achieved by means of direct pressing in a die or a mold or quasi-isotropic pressing in a pressure transmitting medium or by pressing with a roll.

10. Method according to Claim 9, wherein said pressure transmitting medium is molding sand.

11. Method according to any of Claims 1 to 10, wherein the thickness of said sputtered working layer of said target is 1 to 6 mm.

12. Method according to any of Claims 1 to 11, wherein the thickness of said intermediate layer of said target is 0.5 to 4 mm.

13. Method according to any of Claims 1 to 12, wherein the thickness of said metallic solder layer of said target is 0.5 to 5 mm.

## Patentansprüche

1. Verfahren zur Herstellung eines Targets für die Synthese von Beschichtungen unter Anwendung von Ionenplasma-Sputtering, wobei
- wenigstens drei Pellets erzeugt werden, um eine Initiierungsschicht, eine zu zerstäubende Arbeitsschicht und eine Zwischenschicht zu bilden, wobei wenigstens drei Pulvermischungen verwendet werden, die Zusammensetzungen aufweisen, die nach einer lokalen hitzeinitiierten Reaktion zu einer exothermen chemischen Wechselwirkung in einem sich selbst fortpflanzenden Hochtemperatur-Synthese(SHS)-Modus in der Lage sind,
- die genannten Pellets der Initiierungsschicht, der zu zerstäubenden Arbeitsschicht und der Zwischenschicht schichtförmig auf einem geformten Metallplattensubstrat angeordnet sind, das eine Beschickung aus einem schichtförmigen metallischen Lot trägt,
- der SHS-Prozess in der Initiierungsschicht gestartet wird und die entwickelte Hitze das metallische Lot und einen metallischen Füllstoff aufschmilzt, der in der Zusammensetzung der Pulvermischung von wenigstens einer der genannten Schichten enthalten ist,
- Einwirkenlassen eines hohen Drucks durch Pressen innerhalb von 2 bis 10 Sekunden nach dem Abschluss des SHS-Prozesses auf die Schichten, wobei die Dauer der Einwirkung wenigstens 5 Sekunden beträgt,
- Gewinnen eines Target-Produkts, bei dem als Ergebnis des SHS-Prozesses und des Pressens die zu zerstäubende Arbeitsschicht und die Zwischenschicht über die metallische Lotschicht an das geformte Metallplattensubstrat gebunden sind, und
- abschließend Entfernen der Initiierungsschicht.

2. Verfahren nach Anspruch 1, wobei die genannte zu zerstäubende Arbeitsschicht ein Produkt des genannten SHS-Prozesses ist und eine poröse Skelettstruktur aus einem Material, das ein Carbid und/oder Nitrid und/oder Carbonitrid und/oder Borid und/oder Silicid eines Übergangsmetalls der Gruppen IV bis VI des Periodensystems der Elemente und/oder Calciumoxid und/oder Calciumphosphat und/oder Zirkoniumoxid und/oder Hydroxyapatit oder eine Mischung davon enthält, sowie einen metallischen Füllstoff umfasst, der die Poren der porösen Skelettstruktur füllt.

3. Verfahren nach Anspruch 1, wobei die genannte zu zerstäubende Arbeitsschicht ein Produkt des genannten SHS-Prozesses ist und eine poröse Skelettstruktur aus einem Material aufweist, das ein Carbid und/oder Nitrid und/oder Carbonitrid und/oder Borid und/oder Silicid eines Übergangsmetalls der Gruppen IV bis VI des Periodensystems der Elemente und/oder Calciumoxid
und/oder Calciumphosphat und/oder Zirkoniumoxid und/oder Hydroxyapatit oder eine Mischung davon enthält.

4. Verfahren nach Anspruch 1, wobei die genannte Zwischenschicht ein Produkt des genannten SHS-Prozesses ist und eine poröse Skelettstruktur aus einem Material, das ein Carbid und/oder Nitrid und/oder Carbonitrid und/oder Borid und/oder Silicid eines Übergangsmetalls der Gruppen IV bis VI des Periodensystems der Elemente und/oder Calciumoxid und/oder Calciumphosphat und/oder Zirkoniumoxid und/oder Hydroxyapatit oder eine Mischung davon enthält, sowie einen metallischen Füllstoff umfasst, der die Poren der genannten Skelettstruktur der Zwischenschicht in einem Konzentrationsverhältnis füllt, das in Richtung von der Grenzfläche der zu zerstäubenden Arbeitsschicht in Richtung der Grenzfläche des metallischen Lots allmählich zunimmt.

5. Verfahren nach Anspruch 1, wobei die Schicht des metallischen Lots des genannten Targets wenigstens ein Element der Gruppe aufweist, die aus Eisen und/oder. Kupfer und/oder Aluminium und,/oder anderen Übergangsmetallen besteht.

6. Verfahren nach Anspruch 1, wobei während der Herstellung der genannten Pulvermischungen der metallische Füllstoff in Form eines Pulvers in dem keramischen Material verteilt wird, das die poröse Skelettstruktur bildet.

7. Verfahren nach Anspruch 1, wobei während des SHS-Prozesses ein Teil des metallischen Füllstoffes aus der Beschickung des metallischen Lots in die überlagernden Schichten eindringt.

8. Verfahren nach Anspruch 1, wobei die Beschickung des metallischen Lots in Form eines Metallblatts oder von Metallpulver bereitgestellt wird.

9. Verfahren nach Anspruch 1, wobei das Pressen mit Hilfe eines direkten Pressens in einer Form oder Pressform oder als quasi-isotropes Pressen in einem druckübertragenden Medium oder durch Pressen mit einer Walze erreicht wird.

10. Verfahren nach Anspruch 9, wobei das druckübertragende Medium Formsand ist.

11. Verfahren nach irgendeinem der Ansprüche 1 bis 10, wobei die Dicke der zu zerstäubenden Arbeitsschicht des Targets 1 bis 6 mm beträgt.

12. Verfahren nach irgendeinem der Ansprüche 1 bis 11, wobei die Dicke der Zwischenschicht des Targets 0,5 bis 4 mm beträgt.

13. Verfahren nach irgendeinem der Ansprüche 1 bis 12, wobei die Dicke der metallischen Lotschicht des Targets 0,5 bis 5 mm beträgt.

## Revendications

1. Procédé de fabrication d'une cible pour la synthèse de revêtements en utilisant une pulvérisation par plasma ionique, dans lequel
- au moins trois pastilles sont fabriquées pour former une couche d'amorçage, une couche de travail pulvérisée et une couche intermédiaire en utilisant au moins trois mélanges de poudre ayant des compositions capables d'interaction chimique exothermique dans un mode de synthèse à haute température et à auto-propagation (SHS) après une réaction locale amorcée par chaleur,
- lesdites pastilles de ladite couche d'amorçage, ladite couche de travail pulvérisée, et ladite couche intermédiaire étant positionnées par couches sur un substrat en plaque métallique conformé portant une couche de charge de soudure métallique,
- le processus SHS est démarré dans ladite couche d'amorçage et la chaleur développée faire fondre ladite soudure métallique et ladite charge métallique comprise dans la composition du mélange en poudre de l'une au moins desdites couches,
- on expose lesdites couches à une haute pression au moyen d'un pressage en 2 à 10 secondes après la terminaison du processus SHS, la durée de ladite exposition étant au moins cinq secondes,
- on obtient un produit cible dans lequel, en résultat du processus SHS et du pressage, ladite couche de travail pulvérisée et ladite couche intermédiaire sont unies audit substrat en plaque métallique conformé via ladite couche de soudure métallique, et
- on enlève finalement ladite couche d'amorçage.

2. Procédé selon la revendication 1, dans lequel ladite couche de travail pulvérisée est un produit dudit processus SHS et comprend une structure squelette poreuse d'un matériau contenant un carbure et/ou un nitrure et/ou un carbonitrure et/ou un borure et/ou un siliciure d'un métal de transition des groupes IV à VI du tableau périodique des éléments et/ou de l'oxyde de calcium et/ou du phosphate de calcium et/ou de l'oxyde de zirconium et/ou hydroxyapatite, ou un mélange de ceux-ci, et une charge métallique qui remplit les pores de ladite structure squelette poreuse.

3. Procédé selon la revendication 1, dans lequel ladite couche de travail pulvérisée est un produit dudit processus SHS et comprend une structure squelette poreuse d'un matériau contenant un carbure et/ou un nitrure et/ou un carbonitrure et/ou un borure et/ou un siliciure d'un métal de transition des groupes IV à VI du tableau périodique des éléments et/ou de l'oxyde de calcium et/ou du phosphate de calcium et/ou de l'oxyde de zirconium et/ou de l'hydroxyapatite, ou un mélange de ceux-ci.

4. Procédé selon la revendication 1, dans lequel ladite couche intermédiaire est un produit dudit processus SHS et comprend une structure squelette poreuse d'un matériau contenant un carbure et/ou un nitrure et/ou un carbonitrure et/ou un borure et/ou un siliciure d'un métal de transition des groupes IV à VI du tableau périodique des éléments et/ou de l'oxyde de calcium et/ou du phosphate de calcium et/ou de l'oxyde de zirconium et/ou de l'hydroxyapatite ou un mélange de ceux-ci, et une charge métallique qui remplit les pores de ladite structure squelette poreuse de ladite couche intermédiaire dans un rapport de concentration qui augmente progressivement dans la direction depuis l'interface de ladite couche de travail pulvérisée vers l'interface de ladite soudure métallique.

5. Procédé selon la revendication 1, dans lequel ladite couche de soudure métallique de ladite cible comprend au moins un élément du groupe comprenant fer et/ou cuivre et/ou aluminium et/ou d'autres métaux de transition.

6. Procédé selon la revendication 1, dans lequel, pendant la préparation desdits mélanges de poudre, ladite charge métallique est distribuée sous la forme d'une poudre dans ledit matériau céramique formant ladite structure squelette poreuse.

7. Procédé selon la revendication 1, dans lequel pendant le processus SHS une partie de ladite charge métallique pénètre dans les couches qui la recouvrent depuis ladite charge de soudure métallique.

8. Procédé selon la revendication 1, dans lequel ladite charge de soudure métallique est prévue sous la forme d'une feuille métallique ou d'une poudre métallique.

9. Procédé selon la revendication 1, dans lequel ledit pressage est réalisé au moyen d'un pressage direct dans une matrice ou dans un moule, ou un pressage quasi-isotropique dans un milieu transmetteur de pression, ou par pressage avec un rouleau.

10. Procédé selon la revendication 9, dans lequel ledit milieu transmetteur de pression est du sable de moulage.

11. Procédé selon l'une quelconque des revendications 1 à 10, dans lequel l'épaisseur de ladite couche de travail pulvérisée de ladite cible est de 1 à 6 mm.

12. Procédé selon l'une quelconque des revendications 1 à 11, dans lequel l'épaisseur de ladite couche intermédiaire de ladite cible est de 0,5 à 4 mm.

13. Procédé selon l'une quelconque des revendications 1 à 12, dans lequel l'épaisseur de ladite couche de soudure métallique de ladite cible est de 0,5 à 5 mm.
